# EUROPÄISCHE PATENTSCHRIFT

(11) **EP 0 391 923 B1**
(45) Veröffentlichungstag und Bekanntmachung des Hinweises auf die Patenterteilung: **01.06.1994**
(21) Anmeldenummer: 88909076.7
(22) Anmeldetag: 24.10.1988
(51) Int. Cl.: H01L 27/08

(54) **INTEGRIERTE SCHALTUNG MIT ''LATCH-UP''-SCHUTZSCHALTUNG IN KOMPLEMENTÄRER MOS-SCHALTUNGSTECHNIK**
INTEGRATED CIRCUIT WITH ANTI-''LATCH-UP'' CIRCUIT OBTAINED USING COMPLEMENTARY MOS CIRCUIT TECHNOLOGY
CIRCUIT INTEGRE A CIRCUIT DE PROTECTION ANTI-''LATCH-UP'' REALISE SELON LA TECHNIQUE DES CIRCUITS CMOS

(30) Priorität: 23.12.1987 DE 3743931; 27.06.1988 DE 3821644
(43) Veröffentlichungstag der Anmeldung: 17.10.1990
(73) Patentinhaber: SIEMENS AKTIENGESELLSCHAFT, 80333 München (DE)
(72) Erfinder: RECZEK, Werner, D-8000 München 90 (DE); WINNERL, Josef, D-8300 Landshut (DE); PRIBYL, Wolfgang, D-8012 Ottobrunn (DE)
(86) Internationale Anmeldenummer: DE8800648
(87) Internationale Veröffentlichungsnummer: WO8906047

(56) Entgegenhaltungen:
- EP-A- 0 084 000
- EP-A- 0 106 413
- EP-A- 0 198 569
- PATENT ABSTRACTS OF JAPAN, vol. 8, no. 59 (E-232)(1496), 17 March 1984 ; & JP-A-58210658

## Beschreibung

Die Erfindung bezieht sich auf eine integrierte Schaltung mit "Latch-Up"-Schutzschaltung in komplementärer MOS-Schaltungstechnik nach dem Oberbegriff des Patentanspruchs 1.

Bei integrierten Schaltungen dieser Art in komplementärer MOS-Technologie treten parasitäre pnpn-Pfade zwischen der Versorgungsspannung (V_{DD}) und der Masse (V_{SS}) auf, die einem Thyristor ähnlich sind. Diese parasitäre Vierschichtstruktur kann durch Störungen, beispielsweise durch Stromimpulse oder durch Über- oder Unterschwinger der angelegten Versorgungsspannung an den Halbleiterschichten gezündet werden. Der Übergang vom Normalzustand in einen hochleitenden Zustand, d.h. das Zünden dieser Vierschichtstruktur, wird als "Latch-Up" bezeichnet.

Zum Verständnis des "Latch-Up"-Effekts kann man davon ausgehen, daß zwischen einem Anschluß eines in einer wannenförmigen Halbleiterzone liegenden Feldeffekttransistors des ersten Kanaltyps und einem Anschluß eines außerhalb dieser Zone auf dem Halbleitersubstrat plazierten Feldeffekttransistors des zweiten Kanaltyps im allgemeinen vier aufeinanderfolgende Halbleiterschichten alternierender Leitfähigkeitstypen vorhanden sind, wobei das eine Anschlußgebiet des erstgenannten Transistors die erste Halbleiterschicht, die wannenförmigen Halbleiterzone die zweite, das Halbleitersubstrat die dritte und das eine Anschlußgebiet des letzten Transistors die vierte Halbleiterschicht bilden. Aufgrund dieses Aufbaus ergeben sich ein parasitärer bipolarer pnp- und ein npn-Transistor. Der Kollektor des pnp-Transistors entspricht der Basis des npn-Transistors und die Basis des pnp-Transistors dem Kollektor des npn-Transistors. Diese Struktur bildet eine Vierschichtdiode der Schichtenfolge pnpn wie bei einem Thyristor. Bei einer positiven Vorspannung des Halbleitersubstrats kann der pn-Übergang zwischen der dritten und vierten Halbleiterschicht soweit in Durchlaßrichtung vorgespannt werden, daß zwischen den genannten Transistoranschlüssen ein Strompfad entsteht, der auf eine parasitäre Thyristorwirkung innerhalb dieser Vierschichtstruktur zurückzuführen ist. Der Strompfad bleibt dann auch nach einem Abbau der positiven Substratvorspannung bestehen und kann die integrierte Schaltung thermisch überlasten.

Der "Latch-Up"-Effekt ist in dem Fachbuch Halbleiterelektronik 14, H. Weiß, K. Horninger "Integrierte MOS-Schaltungen" auf den Seiten 109 bis 112 beschrieben. Als Abhilfe werden hier eine Änderung der Technologie (Dotierungsprofile) oder Maßnahmen beim Entwurf (Wannenabstände) vorgeschlagen. Ein anderer Lösungsvorschlag, den "Latch-Up"-Effekt, ausgelöst durch Substrat/Verschiebeströme (zum Beispiel beim Einschalten), zu unterbinden, ist in der Veröffentlichung D. Takacs et al. "Static and transient latch-up hardness in n-well CMOS with on-chip substrate bias generator", IEDM 85, Techn. Digest, S. 504 bis 508 dargestellt. Es wird hierein eine Klemmschaltung vorgeschlagen, die einen "Latch-up"-Effekt dadurch verhindert, indem das Halbleitersubstratpotential auf einen Wert begrenzt wird, der nicht ausreicht, die parasitären Bipolartransistoren im Halbleitersubstrat zu aktivieren. Die Klemmschaltung muß dazu die hohen kapazitiven Ladeströme nach Masse abführen.

Aus der europäischen Patentanmeldung EP-A-0 198 569 (Davies) ist eine gegen Latch-up geschützte integrierte Schaltung bekannt, bei der Feldeffekttransistoren der integrierten Schaltung über Dioden mit Masse bzw. einer Versorgungsspannung verbunden sind, wobei diese Dioden vom Substrat der integrierten Schaltung isoliert sind. Ein Nachteil besteht beispielsweise darin, daß infolge der Spannungsabfalle an den Dioden nicht der volle Spannungshub möglich ist.

Ferner ist aus der europäischen Patentanmeldung EP-A-0 084 000 (Chen) eine CMOS-Anordnung bekannt, bei der Latch-up dadurch vermieden wird, daß ein Transistor oder Dioden zwischen einen Feldeffekttransistor und der Versorgungsspannung eingefügt ist und gegebenenfalls ein Spannungsabfall vorgesehen ist, der die Basis eines parasitären Bipolartransistors in Sperrichtung vorspannt.

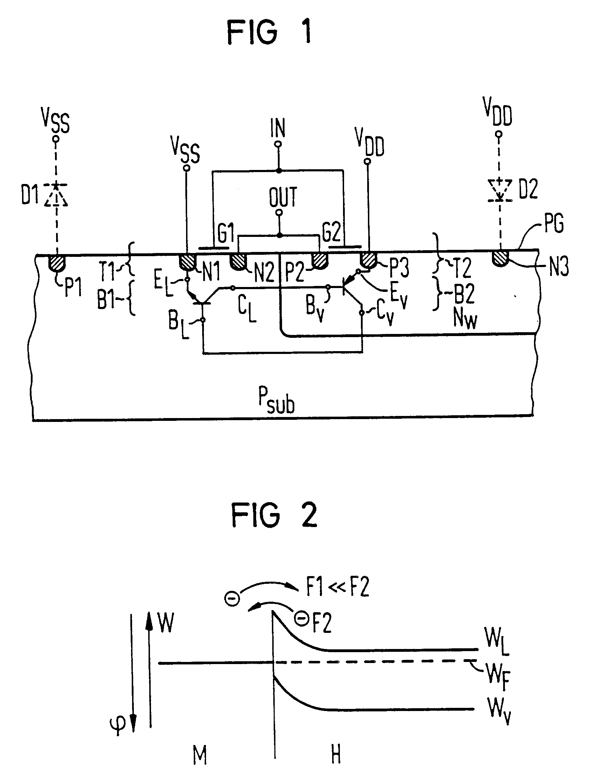

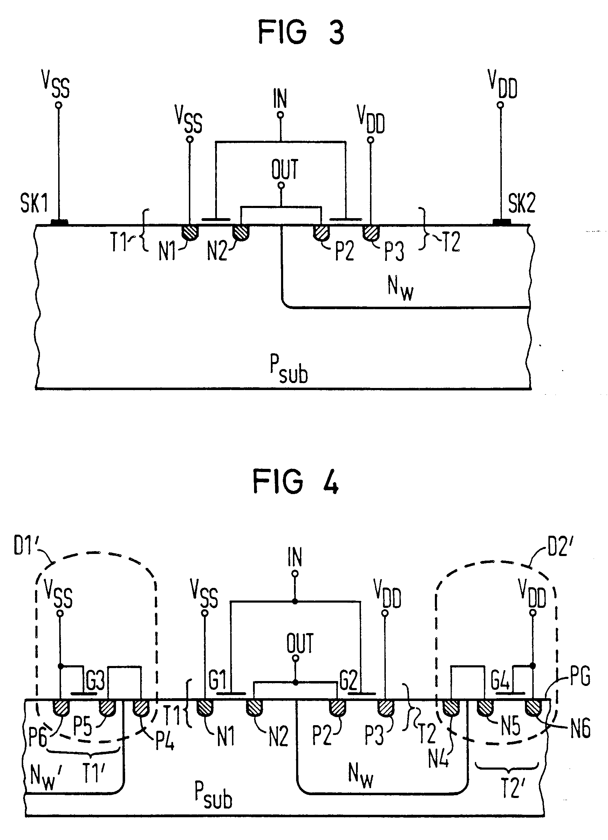

Eine weitere Möglichkeit, den "Latch-Up"-Effekt, hervorgerufen durch Über/Unterschwinger an den Eingangs/Ausgangsanschlüssen, zu unterbinden, liegt in der Verwendung von Schottky-Kontakten, die zwischen den Source-Drain-Anschlüssen der Feleffekttransistoren und dem Halbleitersubstrat oder der wannenförmigen Halbleiterzone beschaltet sind. Aus der Veröffentlichung IEEE Transaction on Electron Devices, Vol. ED-32, No. 2, Febr. 1985 S. 194 bis 202 "A VLSI Suitable Schottky-Barrier CMOS Process" von S. E. Wirhun et al. ist in der Fig. 2 und 3 eine solche Anordnung zu entnehmen. Fig. 2A zeigt hierbei einen Inverter, der in einer n-förmigen Halbleiterzone mit Schottky-Kontakten ausgestattet ist, welche aus Platin-Silizium (PtSi) an den Source- und Drainanschlüssen eines MOS-Transistors gebildet werden. Fig. 3A der obengenannten Veröffentlichung zeigt vergrabene Schottky-Kontakte ebenfalls an den Source- und Drainanschlüssen eines MOS-Transistors in einer wannenförmigen Halbleiterzone. Diese Kontakte sind so angeordnet, daß sie in lateraler Richtung einen ohmschen Kontakt und in vertikaler Richtung einen Schottky-Kontakt für den Stromfluß bilden.

Durch die Einführung der Schottky-Kontakte, wie sie in der Veröffentlichung IEEE Transactions vorgeschlagen wird, kann es zu einer Verschlechterung der MOS-Transistorparameter und zu Schottky-Leckströmen kommen. Außerdem erfordert die Einführung dieser Schottky-Kontakte eine aufwendige Prozeßführung. Durch eine Klemmschaltung, wie sie in der Veröffentlichung von D. Takacs et al angegeben ist, wird prinzipiell nicht die Möglichkeit der positiven Aufladung des Halbleitersubstrats ausgeschlossen, sondern es werden lediglich seine Auswirkungen dadurch kompensiert, daß falls eine positive Aufladung des Halbleitersubstrats erfolgt ist, eine niederohmige Masseverbindung die positive Aufladung wieder abbaut.

Der Erfindung liegt die Aufgabe zugrunde, eine Schaltung der eingangs genannten Art anzugeben, bei der das Auftreten von "Latch-Up"-Effekten weitgehend vermieden wird. Das wird erfindungsgemäß durch eine Ausbildung der Schaltung nach dem kennzeichnenden Teil des Patentanspruchs 1 erreicht.

Die Patentansprüche 2 bis 13 sind auf bevorzugte Ausgestaltungen und Weiterbildungen der Erfindung gerichtet. Der mit der Erfindung erzielbare Vorteil liegt insbesondere darin, daß durch die erfinderische Schaltung die Schalteigenschaften der MOS-Transistoren nicht beeinflußt werden. Weiterhin ist der Platzbedarf für die erfinderische Schaltung sehr gering, da hierfür nur eine geringe Anzahl von Schaltungselementen benötigt wird.

Ausführungsbeispiele der Erfindung sind in den Figuren 3 bis 7 dargestellt. Sie werden im folgenden näher beschrieben. Es zeigt:
- Fig. 1: einen Querschnitt durch einen CMOS-Inverter, bei der die parasitären lateralen und vertikalen Bipolartransistoren mit eingezeichnet sind, die zu "Latch-Up"-Effekten führen können. Das Halbleitersubstrat und die wannenförmige Halbleiterzone sind hierbei über zwei nicht lineare Elemente mit der Masse V_{SS} und der Versorgungsspannung V_{DD} verbunden,
- Fig. 2: ein Bändermodell für einen Metall-n⁺-Halbleiterübergang, der einen Schottky-Kontakt bildet,
- Fig. 3: einen Querschnitt durch einen weiteren CMOS-Inverter, bei dem die ohmschen Wannen- und Substratkontakte durch Schottky-Kontakte ersetzt wurden,
- Fig. 4: einen weiteren Querschnitt durch eine CMOS-Inverterschaltung, bei der das Halbleitersubstrat und die wannenförmige Halbleiterzone über MOS-Transistoren, die als Diodenelemente beschaltet sind, mit der Masse V_{SS} und der Versorgungsspannung V_{DD} angeschlossen sind.

In FIGUR 1 ist eine erfindungsgemäße integrierte Schaltung mit "Latch-Up"-Schutzschaltung schematisch dargestellt, die auf einem Halbleitersubstrat P_{sub} aus dotiertem Halbleitermaterial, z.B. p-leitendem Silizium, aufgebaut ist. Das Halbleitersubstrat P_{sub} weist eine n-leitende wannenförmige Halbleiterzone N_{w} auf, die sich bis zur Grenzfläche P_{G} hin erstreckt. Außerhalb der Halbleiterzone N_{w} sind in das Halbleitersubstrat n⁺-dotierte Halbleitergebiete N1, N2 eingefügt, die das Source- und Draingebiet eines n-Kanal-Feldeffekttransistors T1 bilden, während innerhalb der wannenförmigen Halbleiterzone N_{w} zwei p⁺-dotierte Halbleitergebiete P2, P3 vorhanden sind, die den Drain- und Sourcebereich eines p-Kanal-Feldeffekttransistors T2 darstellen. Im angegebenen Beispiel der Figur 1 sind die Transistoren T1 und T2 als eine CMOS-Inverterstufe verschaltet, wobei das n⁺-dotierte Halbleitergebiet N1 als Sourceanschluß des n-Kanal-Feldeffekttransistors T1 mit der Masse V_{SS} und das n⁺-dotierte Halbleitergebiet N2 als Drainanschluß des n-Kanal-Feldeffekttransistors T1 den Ausgang OUT der CMOS-Inverterstufe bildet. Der p⁺-dotierte Halbleiterbereich P2 ist ebenfalls an den Ausgang OUT gelegt und bildet den Drainanschluß des p-Kanal-Feldeffekttransistors T2, während das p⁺-dotierte Halbleitergebiet P3 als Sourceanschluß desselben Feldeffekttransistors mit der Versorgungsspannung V_{DD} verschaltet ist. Ein Eingangssignal für die CMOS-Inverterstufe wird über den Eingang IN auf ein erstes und zweites Gategebiet G1, G2 des ersten bzw. zweiten Feldeffekttransistors T1, T2 weitergeleitet, während ein Ausgangssignal am Ausgang OUT abgreifbar ist.

Weiterhin eingezeichnet sind die parasitären Bipolartransistoren B1 und B2, welche beide für den "Latch-Up"-Effekt von Bedeutung sind. Der Kollektor C_{L} des lateralen npn-Bipolartransistors B1 ist mit der Basis B_{V} des vertikalen pnp-Bipolartransistors B2, der Basisanschluß B_{L} des lateralen Bipolartransistors B1 mit dem Kollektoranschluß C_{V} des Bipolartransistors B2 verbunden. Der Emitter E_{L} des Bipolartransistors B1 ist weiterhin mit dem Sourceanschluß N1 des Feldeffekttransistors T1 und der Emitter E_{V} des Bipolartransistors B2 ist mit dem Sourceanschluß des Feldeffekttransistors T2 verschaltet. Die parasitären Bipolartransistoren bilden eine Vierschichtdiode pnpn, vergleichbar mit einem Thyristor. Wird nun durch bestimmte Signale die Emitter-Basisdiode zwischen dem Emitter E_{V} und der Basis B_{V} des lateralen Bipolartransistors in Durchlaßrichtung gepolt, so kann der Thyristor zünden. Es fließt dann ein so hoher Strom über die pn-Übergänge, daß entweder die Übergänge oder die Zuleitungen durchschmelzen, was zu einer Zerstörung der CMOS-Inverterstufe führen kann.

Erfindungswesentlicher Teil der CMOS-Inverterstufe stellt der Einbau der nichtlinearen Elemente D1, D2, beispielsweise Elemente mit einer Diodenkennlinie, dar. Hierbei wird das erste nichtlineare Element zwischen einem p⁺-dotierten Halbleitergebiet P1 und der Masse V_{SS} verschaltet, während das zweite nichtlineare Element zwischen einem n⁺-dotierten Halbleitergebiet N3 und der Versorgungsspannung V_{DD} angeordnet ist. Das p⁺-dotierte Halbleitergebiet P1 ist hierbei innerhalb des Halbleitersubstrats P_{sub} und das n⁺-dotierte Halbleitergebiet N3 innerhalb der wannenförmigen Halbleiterzone N_{w} angeordnet. Die Verschaltung der nichtlinearen Elemente D1, D2 für p-leitende wannenförmige Halbleiterzonen erfolgt analog, hierbei ist lediglich der Anschluß der Masse V_{SS} und der Versorgungsspannung V_{DD} zu vertauschen. Das nichtlineare Element D1 bewirkt einerseits, daß Majoritätsladungsträger, die einen Löcherstrom darstellen, niederohmig nach Masse V_{SS} abgeführt werden können und es verhindert andererseits, daß die Basisladung des parasitären lateralen Bipolartransistors B1 über einen nicht eingezeichneten Substratkontakt an der Basis B_{L} aufgebaut werden kann. Das Halbleitersubstrat ist in diesem Falle über das nichtlineare Element D1 mit der Masse V_{SS} niederohmig verbunden. Der Aufbau einer Basisladung des lateralen Bipolartransistors B1 wird nunmehr nur durch einen geringen Sperrstrom des nichtlinearen Elements D1 bestimmt. Dies gilt analog für das nichtlineare Element D2, welches zwischer der n-leitenden wannenförmigen Halbleiterzone N_{w} und der Versorgungsspannung V_{DD} angeschlossen ist. Durch diese Maßnahme wird verhindert, daß die pn-Übergänge der parasitären Bipolartransistoren B1 und B2 in Durchlaßrichtung gepolt werden, was eine Verringerung der "Latch-Up"-Gefahr bedeutet.

Das Verhalten der gesamten CMOS-Schaltung beim Einschalten wird durch den Einbau der nichtlinearen Elemente D1 und D2 nicht beeinträchtigt während im Betrieb auch bei vorhandenen Störimpulsen an n⁺-dotierten Halbleiergebieten N1, an den p⁺-dotierten Halbleitergebieten P3 und an der Klemme OUT die Gefahr eines "Latch-Up" durch die nichtlinearen Elemente D1 und D2 verringert wird. Wichtig dabei ist, daß die nichtlineare Elemente D1, D2 eine Durchlaßspannung besitzen, die geringer ist als die Durchlaßspannung der pn-Übergänge der parasitären Bipolartransistoren B1 und B2.

Die nichtlinearen Elemente D1, D2 können mit Hilfe sog. Schottky-Kontakte realisiert werden. Fig. 2 zeigt hierfür ein Bändermodell im Energie-Ortsdiagramm für einen Schottky-Kontakt, der aus einem Metall M und n⁺-Halbleiter H zusammengesetzt ist. Für eine quantitative Aussage über die Energie W sowie das Potential φ sind diese im linken Teil der Figur 2 als Ordinatenachsen aufgetragen. Das Ferminiveau W_{F} ist sowohl im n-Halbleiterbereich H als auch im Metallbereich M eingezeichnet und gibt den Energiewert im Bändermodell an, bei dem die mittlere Besetzungszahl mit Elektronen 50 % des Maximalwerts beträgt. Für den n⁺-Halbleiter H sind weiterhin die Energieniveaus des Leitungsbandes W_{L} sowie des Valenzbandes W_{V} eingetragen, wobei das Energieniveau des Leitungsbandes W_{L} über dem Fermienergieniveau liegt, und schwächer mit Elektronen besetzt ist, während das Energieniveau des Valzenzbandes W_{V} unterhalb des Fermieenergieniveaus angeordnet ist und stärker mit Elektronen besetzt ist. Ist die Austrittsarbeit für Elektronen aus dem Metall größer als die Austrittsarbeit aus dem Halbleitermaterial, gehen bei einer Kontaktierung zwischen dem n⁺-leitenden Halbleitermaterial und dem Metall Elektronen vom n⁺-Halbleiter in das Metall über. Im thermischen Gleichgewicht verlaufen dann die Fermienergieen von Metall und Halbleiter als gemeinsames elektrochemisches Potential auf gleicher Höhe. Die aus dem Halbleiter übergetretenen Elektronen führen dabei zu einer positiven Raumladung im n⁺-Halbleiter und einer entsprechenden negativen Flächenladung auf der Metalloberfläche. Aufgrund der unterschiedlichen Austrittsarbeit gelangen Elektronen leichter vom n⁺-Halbleitermaterial H in das Metall M als umgekehrt. Dies ist in der Figur 2 durch Pfeile F₁ und F₂ dargestellt, wobei der Elektronenfluß vom Metall M zum n⁺-Halbleiter H mit F₁ und der Elektronenfluß vom n⁺-Halbleitermaterial zum Metall M mit F₂ gekennzeichnet ist. Der Elektronenfluß F₁ ist sehr viel kleiner als der Elektronenfluß F₂. Ein wesentliches Merkmal eines Schottky-Kontaktes gegenüber einem pn-Übergang liegt in der Tatsache, daß im Gegensatz zu diesem nur Majoritätsträger in einer Richtung den Stromtransport bestimmen. Die fehlenden Minoriätsträger verhindern den negativen Einfluß einer p⁺n-Diode auf "Latch-Up". Dies gilt analog für einen Übergang zwischen Metall und p⁺-Halbleiter. Ein wesentlicher Vorteil der Realisierung nichtlinearer Elemente durch Schottky-Kontakte liegt darin, daß bei Unter- oder Überschwinger die Diode D1 bzw. D2 eine Injektion des p⁺-dotierten Halbleitergebiets in die wannenförmige Halbleiterzone und des n⁺-dotierten Halbleitergebiets in das Halbleitersubstrat verhindern und daß diese Kontakte gegenüber normalen pn-Übergängen eine geringere Durchlaßspannung besitzen. Hierdurch werden die pn-Übergänge der parasitären Bipolartransistoren B1 und B2 entlastet, und die Gefahr eines "Latch-Up" weitgehend verhindert. Da bei Schottky-Kontakten der Stromtransport vorwiegend durch Majoritätsträger in einer Richtung bestimmt wird, trägt ein geringer Minoritätsträgeranteil ebenfalls dazu bei, die "Latch-Up"-Gefahr zu verringern, indem ein Aufbau von Basisladungen an den übrigen parasitären Bipolartransistoren unterbunden wird.

Figur 3 zeigt den Querschnitt durch eine CMOS-Inverterschaltung, bei der ohmsche Wannen- und Substratkontakte durch zwei Schottky-Kontakte SK1 und SK2 ersetzt wurden. Innerhalb des p-leitenden Halbleitersubstrats P_{sub} ist eine wannenförmige n-leitende Halbleiterzone N_{w} analog wie in Figur 1 angeordnet. Die CMOS-Inverterschaltung wird wiederum aus zwei MOS-Transistoren, einem n-Kanal-Feldeffekttransistor T1 und einem p-Kanal-Feldeffekttransistor T2 gebildet. Die Verschaltung der beiden Feldeffekttransistoren erfolgt analog wie in Figur 1, so daß gleiche Bezugszeichen in der Figur 3 ebenfalls Verwendung finden. Die zwei nichtlinearen Elemente D1 und D2 aus Figur 1 sind in Figur 3 durch die Schottky-Kontakte SK1 und SK2 realisiert. Während der erste Schottky-Kontakt SK1 zwischen der Masse V_{SS} und dem p-leitenden Halbleitersubstrat P_{sub} geschaltet ist, ist der zweite Schottky-Kontakt SK2 zwischen der Versorgungsspannung V_{DD} und der n-leitenden Halbleiterzone N_{w} angeordnet. Ist das p-leitende Halbleitersubstrat P_{sub} positiv gegenüber der Masse V_{SS} aufgeladen und ist diese Spannungsdifferenz größer als die Durchlaßspannung des ersten Schottky-Kontaktes SK1, können Majoritätsträger, welche einen Löcherstrom bilden, vom p-leitenden Halbleitersubstrat P_{sub} zur Masse V_{SS} abfließen, umgekehrt können jedoch nur eine geringe Anzahl von positiven Raumladungen vom Metallanschluß des ersten Schottky-Kontaktes SK1 in das positive Halbleitersubstrat P_{sub} injiziert werden. Der Aufbau einer Basisladung am parasitären lateralen Bipolartransistor B1 wird somit verhindert. Ist andererseits die n-leitende Halbleiterzone N_{w} negativ aufgeladen, gegenüber der Versorgungsspannung V_{DD} und überschreitet diese Spannungsdifferenz die Durchlaßspannung des zweiten Schottky-Kontaktes SK2, so können Elektronen aus der n-leitenden Halbleiterzone N_{w} über den zweiten Schottky-Kontakt SK2 abfließen. Umgekehrt können jedoch kaum Elektronen vom Metallanschluß des zweiten Schottky-Kontaktes SK2 in die n-leitende Halbleiterzone N_{w} injiziert werden. Hierdurch wird der Aufbau einer Basisladung am parasitären vertikalen Bipolartransistor B2 verhindert.

Ebenfalls ist es möglich, die beiden Metallanschlüsse des ersten und zweiten Schottky-Kontaktes zu zwei Doppelkontakten auszubilden. In diesem Falle überdeckt der Metallanschluß des ersten Schottky-Kontaktes SK1 sowohl Teile des p-dotierten Halbleitersubstrats P_{sub} als auch den Sourceanschluß N1 des MOS-Transistors T1, während der Metallanschluß des zweiten Schottky-Kontaktes SK2 Teile der n-leitenden Halbleiterzone N_{w} und den Sourceanschluß P3 des p-Kanal-MOS-Transistors T2 überdeckt. Im Gegensatz zu Schottky-Source-Drain-Gebieten, wie sie in der Veröffentlichung von S.E. Swirhun et al. "A VLSI Suitable Schottky Barrier CMOS Process" in IEEE Transaction on Electron Devices, Vol. ED 32, No. 2, vom Febr. 1985 auf den Seiten 194 bis 202 angegeben ist, stellen die Sperrströme der Schottky-Kontakte SK1 und SK2 keine Beeinflussung der Schalteigenschaften der MOS-Transistoren dar. Auch wird das Schaltungsverhalten nicht beeinflußt.

Figur 4 zeigt einen weiteren Querschnitt durch eine CMOS-Inverterschaltung. Das p-leitende Halbleitersubstrat P_{sub} ist über einen ersten zusätzlichen MOS-Transistor T1', der als ein Diodenelement verschaltet ist, mit der Masse V_{SS} und die n-leitende wannenförmige Halbleiterzone N_{w} ist über einen als Diodenelement verschalteten zweiten zusätzlichen MOS-Transistor T2' mit der Versorgungsspannung V_{DD} verbunden. In dem p-leitenden Halbleitersubstrat P_{sub} ist neben der n-leitenden wannenförmigen Halbleiterzone N_{w} eine weitere n-leitende Halbleiterzone N_{w}' angeordnet, wobei beide sich bis zu einer Grenzfläche PG hin erstrecken. Das p-leitende Halbleitersubstrat P_{sub} enthält weiterhin zwei n⁺-dotierte Halbleitergebiete N1 und N2, die zusammen mit dem Gategebiet G1 den n-Kanal-Feldeffekttransistor T1 bilden, während die n-leitende wannenförmige Halbleiterzone N_{w} zwei p⁺-dotierte Halbleitergebiete P2 und P3 aufweist, die zusammen mit dem Gategebiet G2 den p-Kanal-Feldeffekttransistor T2 darstellen. Die Inverterschaltung nach Figur 4 ist analog zu der in Figur 1 aufgebaut, so daß das n⁺-dotierte Halbleitergebiet N1 als Sourceanschluß des Feldeffekttransistors T1 mit der Masse V_{SS} und das n⁺-dotierte Halbleitergebiet N2 als Drainanschluß des Feldeffekttransistors T1 den Ausgang OUT der Inverterstufe bildet. Weiterhin ist der p⁺-dotierte Halbleiterbereich P2 ebenfalls an den Ausgang OUT angeschlossen und bildet den Drainanschluß des p-Kanal-Feldeffekttransistors T2, während das p⁺-dotierte Halbleitergebiet P3 als Sourceanschluß desselben Feldeffekttransistors mit der Versorgungsspannung V_{DD} verschaltet ist. Die Eingangssignale für die Inverterstufe werden am Eingang IN angelegt und Ausgangssignale können am Ausgang OUT abgegriffen werden.

Die Realisierung der nichtlinearen Elemente durch zusätzliche MOS-Transistoren eignet sich besonders für "Latch-Up"-sichere Ausgangsstufen, für die beim verwendeten Herstellungsprozeß keine Schottky-Kontakte vorgesehen sind. Der entstehende Mehrbedarf an Platz ist hierbei gering. Der erste zusätzliche MOS-Transistor T1' ist aus p-leitenden Halbleitergebieten P6 und P5 sowie aus einem Gategebiet G3 aufgebaut, wobei die p-leitenden Halbleitergebiete P6 und P5 innerhalb der weiteren n-leitenden Halbleiterzone N_{w}' angeordnet sind, und die p-leitende Halbleiterzone P5 mit einer weiteren p-leitenden Halbleiterzone P4, die sich innerhalb des p-leitenden Halbleitersubstrats P_{sub} befindet, verbunden ist. Der Drainanschluß des ersten zusätzlichen MOS-Transistors T1', der aus dem p⁺-dotierten Halbleitergebiet P6 gebildet wird und das Gategebiet G3 sind gemeinsam an der Masse V_{SS} angeschlossen. Der zweite zusätzliche MOS-Transistor T2' enthält zwei n⁺-dotierte Halbleitergebiete N5 und N6, welche beide innerhalb des p-leitenden Halbleitersubstrats P_{sub} angeordnet sind, sowie ein Gategebiet G4. Das Gategebiet G4 sowie das n⁺-dotierte Halbleitergebiet N6, welches den Drainanschluß des zweiten zusätzlichen MOS-Transistor T2' darstellt, ist hierbei gemeinsam mit der Versorgungsspannung V_{DD} verschaltet. Das n⁺-dotierte Halbleitergebiet N5, das den Sourceanschluß des zweiten zusätzlichen MOS-Transistors T2 bildet, ist mit einem weiteren n⁺-dotierten Halbleitergebiet N4 verbunden, das sich innerhalb der n-leitenden wannenförmigen Halbleiterzone N_{w} befindet.

Der erste zusätzliche MOS-Transistor T1' bildet gemeinsam mit dem weiteren p⁺-dotierten Halbleitergebiet P4 ein Diodenelement D1', das zwischen der Masse V_{SS} und dem p⁺-dotierten Halbleitergebiet P4 verschaltet ist. Der zweite zusätzliche MOS-Transistor T2' ist durch die Verbindung des n⁺-dotierten Halblietergebiets N5 mit dem n⁺-dotierten Halbleitergebiet N4 und der gemeinsamen Verschaltung des Gateanschlusses G4 mit dem n⁺-dotierten Halbleitergebiet N6 mit der Versorgungsspannung V_{DD} als ein weiteres Diodenelement D2' beschaltet, das zwischen der Versorgungsspannung V_{DD} und dem n⁺-dotierten Halbleitergebiet N4 angeordnet ist. Das Diodenelement D1', welches zwischen der Masse V_{SS} und dem p-leitenden Substrat P_{sub} angeordnet ist, wird wie aus Figur 4 zu ersehen ist, durch einen p-leitenden MOS-Transistor T1' realisiert, während das Diodenelement D2', welches zwischen der Versorgungsspannung V_{DD} und der n-leitenden wannenförmigen Halbleiterzone N_{w} angeordnet ist, mit Hilfe eines n-leitenden MOS-Transistors T2' aufgebaut wird. Die Funktionsweise der angegebenen Schaltung in Figur 4 gleicht der Funktionsweise der Schaltung nach Figur 3. Sobald die Spannungsdifferenz zwischen dem p-leitenden Halbleitersubstrat P_{sub} und der Masse V_{SS} die Durchlaßspannung des Diodenelements D1' überschreitet, leitet dieses und sobald am Diodenelement D2' zwischen der Versorgungsspannung V_{DD} und der n-leitenden Halbleiterzone N_{W} eine Spannungsdifferenz auftritt, die großer ist als die Durchlaßspannung desselben Diodenelements, geht das Diodenelement D2' in den leitfähigen Zustand über. Durch diese Maßnahmen kann verhindert werden, daß die Basisladungen der hier nicht eingezeichneten lateralen und vertikalen Bipolartransistoren aufgebaut werden. Die "Latch-Up"-Gefahr wird somit deutlich reduziert.

Neben den oben behandelten Ausführungsformen umfaßt die Erfindung auch solche, bei denen n-leitendes Substrat mit p-leitenden wannenförmigen Halbleiterzonen versehen sind. Dabei werden die Leitungstypen sämtlicher Halbleiterteile und die Polaritäten sämtlicher Spannungen durch die jeweils entgegengesetzten ersetzt. Ebenso kann das erste nichtlineare Element zwischen einem p⁺-dotierten Halbleitergebiete P1 und negativem Substratpotential (V_{BB} < V_{SS}) verschaltet werden, während das zweite nichtlineare Element zwischen einem n⁺-dotierten Halbleitergebiet N3 und positivem Wannenpotential (V_{well} > V_{DD}) verschaltet werden kann.

Bei einer weiteren vorteilhaften Ausführungsform sind zwei in Serie zueinander geschaltete MOS-Transistoren T1, T2 vom zueinander komplementären Leitungstyp vorgesehen. Der Transistor T1 ist vom NMOS-Typ. Der Transistor T2 ist vom PMOS-Typ. Der Transistor T1 ist in p-leitendem Substrat P_{sub} angeordnet. Der Transistor T2 ist in einer n-leitenden wannenförmigen Halbleiterzone N_{W} angeordnet. Die bei MOS-Transistoren üblichen Diffusionsgebiete für Source und Drain sind mit N1 und N2 bzw. P3 und P2 bezeichnet. Das Substrat P_{sub} enthält ein stärker dotiertes Halbleitergebiet P1 vom selben Leitungstyp wie das Substrat selbst. Entsprechend enthält die wannenförmige Halbleiterzone N_{W} ein stärker dotiertes Halbleitergebiet N3 vom selben Leitungstyp wie die Halbleiterzone selbst. Solche stärker dotierten Halbleitergebiete werden in CMOS-Technologie allgemein verwendet. Die Gates der Transistoren sind mit G1 und G2 bezeichnet.

Oberhalb des Substrates P_{sub} und der wannenförmigen Halbleiterzone N_{w} sind außer den Gates G1,G2 auch elektrische Leiterbahnen zur Zuführung von Masse V_{SS} und Versorgungspotential V_{DD} angeordnet sowie eine elektrisch leitende Verbindung (z.B. aus Aluminium) zwischen den Drains N2,P2 der beiden Transistoren T1, T2. Sie kann beispielsweise als Ausgang OUT eines aus den beiden Transistoren T1,T2 gebildeten CMOS-Inverters dienen. Die verschiedenen elektrisch leitenden Bereiche oberhalb von Substrat P_{sub} und wannenförmiger Halbleiterzone N_{w} sind, wie allgemein üblich, durch Oxide Ox oder sonstige Isolierschichten (z.B. Nitrid) elektrisch voneinander getrennt. Die oberste Oxidschicht kann dabei als Passivierungsschicht ausgebildet sein.

Die nichtlinearen Elemente D1,D2 sind bei dieser Ausführungsform als vergrabene Dioden realisiert. Dazu ist innerhalb derjenigen Oxidschichten Ox, die die Diffusionsgebiete N1,P3 (Sources) der Transistoren T1,T2 und die stärker dotierten Halbleitergebiete P1,N3 mindestens teilweise bedecken, jeweils eine elektrisch leitende Schicht vorgesehen, die im wesentlichen dotiertes polykristallines Silizium PSi enthält. Je nach verwendeter Technologie (N-Wannen-Prozeß, P-Wannen-Prozeß, sowohl N- wie auch P-Wannen-Prozeß für die Transistoren T1 und T2) ist der Leitungstyp der polykristallinen Siliziumschicht PSi entweder entgegengesetzt zum Leitungstyp des Substrates P_{sub} und/oder entgegengesetzt zu dem der (einen) wannenförmigen Halbleiterzone N_{w} bzw. der wannenförmigen Halbleiterzonen (mehrere vom einander entgegengesetzten Leitungstyp).

Die nichtlinearen Elemente D1,D2 sind als Sperrschichtdioden ausgebildet. Ihr erster Anschluß, der jeweils im wesentlichen aus der polykristalinen Siliziumschicht PSi besteht, ist dabei über ohm'sche Kontakte K1,K2 mit Massepotential V_{SS} verbunden (Verbindung entweder über Source-Diffusionsgebiet N1 oder direkt mit der Leiterbahn) bzw. mit dem stärker dotierten Halbleitergebiet N3, das vom selben Leitungstyp ist wie das polykristalline Silizium PSi.

Entsprechend sind die zweiten Anschlüsse der nichtlinearen Elemente D1,D2 mit dem stärker dotierten Halbleitergebiet P1 verbunden (dieses ist ja vom zur polykristallinen Siliziumschicht PSi entgegengesetzten Leitungstyp) bzw. über das Source-Diffusionsgebiet P3 mit dem Versorgungspotential V_{DD}. Auf diese Weise bilden sich im Bereich dieser Verbindungen die Sperrschichtdioden aus.

Die Ausführungsform weist folgende Vorteile auf:
Polykristalline Siliziumschichten werden bereits bei üblichen CMOS-Prozessen abgeschieden. Es ist somit lediglich eine Maskenänderung vorzusehen; es fallen jedoch keinerlei zusätzliche Prozeßschritte an.

Sind die zuvor beschriebenen Schottky-Kontakte beispielsweise aus Gründen, die in einem verwendeten, speziellen Herstellungsprozeß liegen, nicht erzeugbar, so bietet die vorliegende Ausführung eine elegante Alternative.

Weiterhin ist kein zusätzlicher Flächenbedarf notwendig, da die stärker dotierten Halbleitergebiete P1 und N3 bei einem üblichen CMOS-Design sowieso schon vorhanden sind beispielsweise in Form von sog. "guard rings" und da der Platzbedarf für das polykristalline Silizium PSi im allgemeinen keine sonstigen Schaltungsteile verdrängt. Weiterhin ist die Stromergiebigkeit bei dieser Ausführung größer als bei den zuvor beschriebenen Ausführungsformen, was zu einem noch größeren Schutz vor dem gefürchteten Latch-Up-Effekt führt.

## Patentansprüche

1. Integrierte Schaltung mit "Latch-up"-Schutzschaltung in komplementärer MOS-Schaltungstechnik mit einem dotierten Halbleitersubstrat (P_{sub}) eines ersten Leitungstyps, das einen ersten Feldeffekttransistor enthalt, dessen Kanal den ersten Leitungstyp aufweist und bei dem ein Anschluß direkt mit Masse (V_{SS}) verbunden ist, und mit in dem dotierten Halbleitersubstrat (P_{sub}) eingefügten wannenförmigen Halbleiterzonen (N_{w}) eines zweiten Leitungstyps, die einen zweiten Feldeffekttransistor enthalten, dessen Kanal den zweiten Leitungstyp aufweist und bei dem ein Anschluß direkt mit einer Versorgungsspannung (V_{DD}) verbunden ist,
**dadurch gekennzeichnet,**
daß die "Latch-Up"-Schutzschaltung nichtlineare Elemente (D1, D2) enthält, und ein erstes nichtlineares Element (D1) mit einem ersten Anschluß an Masse (V_{SS}) und mit einem zweiten Anschluß an dem dotierten Halbleitersubstrat (P_{sub}) eines ersten Leitungstyps und ein zweites nichtlineares Element (D2) mit einem ersten Anschluß an die Versorgungsspannung (V_{DD}) und mit einem zweiten Anschluß an der eingefügten wannenförmigen Halbleiterzone (N_{w}) eines zweiten Leitungstyps geschaltet sind.

2. Integrierte Schaltung nach Anspruch 1,
**dadurch gekennzeichnet,**
daß das Halbleitersubstrat (P_{sub}) eines ersten Leitungstyps durch eine wannenförmige Halbleiterzone des ersten Leitungstyps ersetzt wird, die den ersten Feldeffekttransistor enthält, und daß die wannenförmige Halbleiterzone (N_{w}) eines zweiten Leitungstyps durch ein Halbleitersubstrat des zweiten Leitungstyps ersetzt wird, das den zweiten Feldeffekttransistor enthäkt, und daß die wannenförmige Halbleiterzone des ersten Leitungstyps in das Halbleitersubstrat des zweiten Leitungstyps eingefügt ist und daß ein erstes nichtlineares Element (D1) mit einem ersten Anschluß an einer eingefügten wannenförmigen Halbleiterzone (P_{sub}) eines ersten Leitungstyps und ein zweites nichtlineares Element (D2) mit einem ersten Anschluß an einer Versorgungsspannung (V_{DD}) und mit einem zweiten Anschluß an dem dotierten Halbleitersubstrat (N_{w}) eines zweiten Leitungstyps geschaltet ist.

3. Integrierte Schaltung nach Anspruch 1 oder 2, **dadurch gekennzeichnet,** daß ein erster Anschluß eines ersten nichtlinearen Elements durch einen Anschluß an negatives Substratpotential ersetzt wird und/oder daß ein erster Anschluß eines zweiten nichtlinearen Elements durch einen Anschluß mit positiverem Potential als die Versorgungsspannung (V_{DD}) ersetzt wird.

4. Integrierte Schaltung nach Anspruch 1, 2 oder 3, **dadurch gekennzeichnet,** daß die nichtlinearen Elemente als Schottky-Kontakte (SK1, SK2) ausgebildet sind.

5. Integrierte Schaltung nach Anspruch 4, **dadurch gekennzeichnet,** daß das dotierte Halbleitersubstrat (P_{sub}) eines ersten Leitungstyps einen Feldeffekttransistor eines ersten Kanaltyps (T1) und die eingefügte wannenförmige Halbleiterzone eines zweiten Kanaltyps (T2) einen Feldeffekttransistors eines zweiten Kanaltyps enthält, daß ein Metallkontakt des Schottky-Kontakts des ersten nichtlinearen Elements (SK1) einen ersten Anschluß des Feldeffekttransistors des ersten Kanaltyps (T1) und das dotierte Halbleitersubstrat eines ersten Leitungstyps (P_{sub}) überdeckt, und einen ersten Doppelkontakt bildet und daß ein Metallkontakt des Schottky-Kontakts des zweiten nichtlinearen Elements (SK2) einen ersten Anschluß des Feldeffekttransistors des zweiten Kanaltyps (T2) und eine wannenförmige Halbleiterzone eines zweiten Kanaltyps (N_{w}) überdeckt und einen zweiten Doppelkontakt bildet.

6. Integrierte Schaltung nach Anspruch 1, 2 oder 3, **dadurch gekennzeichnet,** daß die nichtlinearen Elemente durch MOS-Transistoren (T1', T2') realisiert sind, die als Diodenelemente beschaltet sind.

7. Integrierte Schaltung nach Anspruch 6, **dadurch gekennzeichnet,** daß ein erster MOS-Transistor eines ersten Kanaltyps (T1') innerhalb einer eingefügten weiteren wannenförmigen Halbleiterzone (N_{w}') eines zweiten Leitungstyps angeordnet ist, daß ein erster Anschluß des ersten MOS-Transistors (T1') mit einem Gate (G3) des ersten MOS-Transistors (T1') verschaltet ist und ein zweiter Anschluß des ersten MOS-Transistors (T1') mit dem dotierten Halbleitersubstrat eines ersten Leitungstyps (P_{sub}) verbunden ist, daß ein zweiter MOS-Transistor eines zweiten Kanaltyps (T2') innerhalb des dotierten Halbleitersubstrats eines ersten Leitungstyps (P_{sub} ) angeordnet ist, daß ein erster Anschluß des zweiten MOS-Transistors (T2') mit einem Gate (G4) des zweiten MOS-Transistors (T2') verschaltet ist und ein zweiter Anschluß des zweiten MOS-Transistors mit einer eingefügten wannenförmigen Halbleiterzone eines zweiten Leitungstyps (N_{w}) verbunden ist.

8. Integrierte Schaltung nach Anspruch 1, **dadurch gekennzeichnet**, daß die nichtlinearen Elemente (D1,D2) in Form vergrabener Dioden realisiert sind.

9. Integrierte Schaltung nach Anspruch 8, **dadurch gekennzeichnet**, daß die nichtlinearen Elemente (D1,D2) im wesentlichen dotiertes polykristallines Silizium (PSi) vom zum Substrat (P_{sub}) entgegengesetzten Leitungstyp enthalten.

10. Integrierte Schaltung nach Anspruch 8 oder 9, **dadurch gekennzeichnet**, daß die nichtlinearen Elemente (D1,D2) im wesentlichen polykristallines Silizium (PSi) vom zur wannenförmigen Halbleiterzone (N_{w}) entgegengesetzten Leitungstyp enthalten.

11. Integrierte Schaltung nach einem der Ansprüche 8 bis 10, **dadurch gekennzeichnet**, daß die nichtlinearen Elemente (D1,D2) als Sperrschichtdioden ausgebildet sind.

12. Integrierte Schaltung nach einem der Ansprüche 8 bis 11, **dadurch gekennzeichnet**, daß die ersten Anschlüsse der nichtlinearen Elemente (D1,D2) über ohm'sche Kontakte (K1,K2) mit Massepotential (V_{SS}) bzw. mit einem stärker dotierten Halbleitergebiet (N3) vom zum polykristallinem Silizium (PSi) entgegengesetzten Leitungstyp verbunden sind.

13. Integrierte Schaltung nach einem der Ansprüche 8 bis 12, **dadurch gekennzeichnet**, daß die zweiten Anschlüse der nichtlinearen Elemente (D1,D2) mit einem stärker dotiereten Halbleitergebiet (P1) vom selben Leitungstyp wie das polykristalline Silizium (PSi) bzw. über din Diffusionsgebiet (P3) mit dem Versorgungspotential (V_{DD}) verbunden sind unter Bildung der Sperrschichtdioden.

## Claims

1. Integrated circuit having "latch-up" protection circuit employing complementary MOS circuitry, having a doped semiconductor substrate (P_{sub}) of a first conduction type comprising a first field-effect transistor whose channel is of the first conduction type and in which one terminal is connected directly to earth (V_{SS}) and having well-shaped semiconductor zones (N_{w}) of a second conduction type which are inserted in the doped semiconductor substrate (P_{sub}) and which comprises a second field-effect transistor whose channel is of the second conduction type and in which one terminal is connected directly to a supply voltage (V_{DD}), characterized in that the "latch-up" protection circuit comprises nonlinear components (D1, D2), and a first nonlinear component (D1) is connected by means of a first terminal to earth (V_{SS}) and by means of a second terminal to the doped semiconductor substrate (P_{sub}) of a first conduction type and a second nonlinear component (D2) is connected by means of a first terminal to the supply voltage (V_{DD}) and by means of a second terminal to the inserted well-shaped semiconductor zone (N_{w}) of a second conduction type.

2. Integrated circuit according to Claim 1, characterized in that the semiconductor substrate (P_{sub}) of a first conduction type is replaced by a well-shaped semiconductor zone of the first conduction type which comprises the first field-effect transistor and in that the well-shaped semiconductor zone (N_{w}) of a second conduction type is replaced by a semiconductor substrate of the second conduction type which comprises the second field-effect transistor, and in that the well-shaped semiconductor zone of the first conduction type is inserted in the semiconductor substrate of the second conduction type and in that a first nonlinear component (D1) is connected by means of a first terminal to an inserted well-shaped semiconductor zone (P_{sub}) of a first conduction type and a second nonlinear component (D2) is connected by means of a first terminal to a supply voltage (V_{DD}) and by means of a second terminal to the doped semiconductor substrate (N_{w}) of a second conduction type.

3. Integrated circuit according to Claim 1 or 2, characterized in that a first terminal of a first nonlinear component is replaced by a terminal at negative substrate potential and/or in that a first terminal of a second nonlinear component is replaced by a terminal having more positive potential than the supply voltage (V_{DD}).

4. Integrated circuit according to Claim 1, 2 or 3, characterized in that the nonlinear components are designed as Schottky contacts (SK1, SK2).

5. Integrated circuit according to Claim 4, characterized in that the doped semiconductor substrate (P_{sub}) of a first conduction type comprises a field-effect transistor of a first channel type (T1) and the inserted well-shaped semiconductor zone of a second channel type (T2) comprises a field-effect transistor of a second channel type, in that a metal contact of the Schottky contact of the first nonlinear component (SK1) covers a first terminal of the field-effect transistor of the first channel type (T1) and the doped semiconductor substrate of a first conduction type (P_{sub}) and forms a first double contact, and in that a metal contact of the Schottky contact of the second nonlinear component (SK2) covers a first terminal of the field-effect transistor of the second channel type (T2) and a well-shaped semiconductor zone of a second channel type (N_{w}) and forms a second double contact.

6. Integrated circuit according to Claim 1, 2 or 3, characterized in that the nonlinear components are formed by MOS transistors (T1', T2') which are connected as diode components.

7. Integrated circuit according to Claim 6, characterized in that a first MOS transistor of a first channel type (T1') is disposed inside an inserted further well-shaped semiconductor zone (N_{w}') of a second conduction type, in that a first terminal of the first MOS transistor (T1') is connected to a gate (G3) of the first MOS transistor (T1') and a second terminal of the first MOS transistor (T1') is connected to the doped semiconductor substrate of a first conduction type (P_{sub}), in that a second MOS transistor of a second channel type (T2') is disposed inside the doped semiconductor substrate of a first conduction type (P_{sub}), and in that a first terminal of the second MOS transistor (T2') is connected to a gate (G4) of the second MOS transistor (T2') and a second terminal of the second MOS transistor is connected to an inserted well-shaped semiconductor zone of a second conduction type (N_{w}).

8. Integrated circuit according to Claim 1, characterized in that the nonlinear components (D1, D2) are constructed in the form of buried diodes.

9. Integrated circuit according to Claim 8, characterized in that the nonlinear components (D1, D2) essentially comprise doped, polycrystalline silicon (PSi) of the conduction type opposite to that of the substrate (P_{sub}).

10. Integrated circuit according to Claim 8 or 9, characterized in that the nonlinear components (D1, D2) essentially comprise polycrystalline silicon (PSi) of the conduction type opposite to that of the well-shaped semiconductor zone (N_{w}).

11. Integrated circuit according to one of Claims 8 to 10, characterized in that the nonlinear components (D1, D2) are designed as barrier-layer diodes.

12. Integrated circuit according to one of Claims 8 to 11, characterized in that the first terminals of the nonlinear components (D1, D2) are connected via ohmic contacts (K1, K2) to earth potential (V_{SS}) or to a more heavily doped semiconductor region (N3) of the conduction type opposite to that of the polycrystalline silicon (PSi).

13. Integrated circuit according to one of Claims 8 to 12, characterized in that the second terminals of the nonlinear components (D1, D2) are connected to a more heavily doped semiconductor region (P1) of the same conduction type as that of the polycrystalline silicon (PSi) or via a diffusion region (P3) to the supply potential (V_{DD}) to form the barrier-layer diodes.

## Revendications

1. Circuit intégré comportant un circuit de protection de l'effet de "Latch-up" en technique de circuits MOS complémentaires et comportant un substrat semiconducteur dopé (P_{sub}) d'un premier type de conductivité, qui comporte un premier transistor à effet de champ, dont le canal a le premier type de conductivité et dans lequel une borne est reliée directement à la masse (V_{SS}), et comportant des zones semiconductrices en forme de cuvettes (N_{w}) d'un second type de conductivité, qui sont insérées dans le substrat semiconducteur dopé (P_{sub}) et qui comportent un second transistor à effet de champ, dont le canal a le second type de conductivité et dans lequel une borne est reliée directement à une tension d'alimentation (V_{DD}), caractérisé par le fait que le circuit de protection de l'effet de "Latch-up" comporte des éléments non linéaires (D1, D2), et qu'un premier élément non linéaire (D1) est relié, par une première borne, à la masse (V_{SS}) et, par une seconde borne, au substrat semiconducteur dopé (P_{sub}) d'un premier type de conductivité, et qu'un second élément non linéaire (D2) est relié, par une première borne, à la tension d'alimentation (V_{DD}) et, par une seconde borne, à la zone semiconductrice en forme de cuvette insérée (N_{w}) d'un second type de conductivité.

2. Circuit intégré selon la revendication 1, caractérisé par le fait que le substrat semiconducteur (P_{sub}) d'un premier type de conductivité est remplacé par une zone semiconductrice en forme de cuvette du premier type de conductivité, qui comporte le premier transistor à effet de champ, que la zone semiconductrice en forme de cuvette (N_{w}) d'un second type de conductivité est remplacée par un substrat semiconducteur du second type de conductivité, qui comporte le second transistor à effet de champ, que la zone semiconductrice en forme de cuvette du premier type de conductivité est insérée dans le substrat semiconducteur du second type de conductivité, qu'un premier élément non linéaire (D1) est relié, par une première borne, à une zone semiconductrice en forme de cuvette insérée (P_{sub}) d'un premier type de conductivité et qu'un second élément non linéaire (D2) est relié, par une première borne, à une tension d'alimentation (V_{DD}) et, par une seconde borne, au substrat semiconducteur dopé (N_{w}) d'un second type de conductivité.

3. Circuit intégré suivant la revendication 1 ou 2, caractérisé par le fait qu'une première borne d'un premier élément non linéaire est remplacée par une borne reliée à un potentiel de substrat négatif et/ou qu'une première borne d'un second élément non linéaire est remplacée par une borne reliée à un potentiel plus positif que la tension d'alimentation (V_{DD}).

4. Circuit intégré suivant la revendication 1, 2 ou 3, caractérisé par le fait que les éléments non linéaires sont sous la forme de contacts Schottky (SK1, SK2).

5. Circuit intégré suivant la revendication 4, caractérisé par le fait que le substrat semiconducteur dopé (P_{sub}) d'un premier type de conductivité comporte un transistor à effet de champ d'un premier type de canal (T1) et que la zone semiconductrice en forme de cuvette insérée d'un second type de conductivité comporte un transistor à effet de champ d'un second type de canal (T2), qu'un contact métallique du contact Schottky du premier élément non linéaire (SK1) recouvre une première borne du transistor à effet de champ du premier type de canal (T1) et le substrat semiconducteur dopé (P_{sub}) d'un premier type de conductivité, et forme un premier contact double, et qu'un contact métallique du contact Schottky du second élément non linéaire (SK2) recouvre une première borne du transistor à effet de champ du second type de canal (T2) et une zone semiconductrice en forme de cuvette (N_{w}) d'un second type de canal et forme un second contact double.

6. Circuit intégré suivant la revendication 1, 2 ou 3, caractérisé par le fait que les éléments non linéaires sont des transistors MOS (T1', T2'), qui sont montés en tant qu'éléments de diodes.

7. Circuit intégré suivant la revendication 6, caractérisé par le fait qu'un premier transistor MOS d'un premier type de canal (T1') est disposé à l'intérieur d'une autre zone (N_{w}') semiconductrice en forme de cuvette, insérée, d'un second type de conductivité, qu'une première borne du premier transistor MOS (T1') est reliée à une grille (G3) du premier transistor MOS (T1'), et qu'une seconde borne du premier transistor MOS (T1') est reliée au substrat semiconducteur dopé d'un premier type de conductivité (P_{sub}), qu'un second transistor MOS d'un second type de canal (T2') est disposé à l'intérieur du substrat semiconducteur dopé d'un premier type de conductivité (P_{sub}), qu'une première borne du second transistor MOS (T2') est reliée à une grille (G4) du second transistor MOS (T2') et qu'une seconde borne du second transistor MOS est reliée à une zone semiconductrice en forme de cuvette, insérée et d'un second type de conductivité (N_{w}).

8. Circuit intégré suivant la revendication 1, caractérisé par le fait que les éléments non linéaires (D1, D2) sont sous la forme de diodes ensevelies.

9. Circuit intégré suivant la revendication 8, caractérisé par le fait que les éléments non linéaires (D1, D2) contiennent essentiellement du silicium polycristallin dopé (PSi) ayant le type de conductivité opposé à celui du substrat (P_{sub}).

10. Circuit intégré suivant la revendication 8 ou 9, caractérisé par le fait que les éléments non linéaires (D1, D2) contiennent essentiellement du silicium polycristallin (PSi) ayant le type de conductivité opposé à celui de la zone semiconductrice (N_{w}) en forme de cuvette.

11. Circuit intégré suivant l'une des revendications 8 à 10, caractérisé par le fait que les éléments non linéaires (D1, D2) sont des diodes à couche de blocage.

12. Circuit intégré suivant l'une des revendications 8 à 11, caractérisé par le fait que les premières bornes des éléments non linéaires (D1, D2) sont reliées, par l'intermédiaire de contacts ohmiques (K1, K2), au potentiel de masse (V_{SS}) ou à une région semiconductrice (N3) plus fortement dopée et ayant le type de conductivité opposé à celui du silicium polycristallin (PSi).

13. Circuit intégré suivant l'une des revendications 8 à 12, caractérisé par le fait que les secondes bornes des éléments non linéaires (D1, D2) sont reliées à une région semiconductrice (P1) plus fortement dopée et ayant le même type de conductivité que celui du silicium polycristallin (PSi), ou, par l'intermédiaire d'une région de diffusion (P3), au potentiel d'alimentation (V_{DD}), moyennant la formation des diodes à couche de blocage.
